Europäisches Patentamt

European Patent Office

Office européen des brevets

(11) Publication number: **0 298 157 B1**

## EUROPEAN PATENT SPECIFICATION

(45) Date of publication of patent specification: **02.09.92**  (51) Int. Cl.5: **C23C 14/32**

(21) Application number: **87201244.8**

(22) Date of filing: **29.06.87**

(54) **Method and device for coating cavities of objects.**

(43) Date of publication of application:
**11.01.89 Bulletin 89/02**

(45) Publication of the grant of the patent:
**02.09.92 Bulletin 92/36**

(84) Designated Contracting States:
**AT BE CH DE ES FR GB IT LI LU NL SE**

(56) References cited:
**EP-A- 0 099 724        EP-A- 0 284 145
DE-A- 2 820 301        DE-A- 3 150 591
GB-A- 1 482 219        GB-A- 2 139 648
US-A- 4 468 309**

**PATENT ABSTRACTS OF JAPAN, vol. 1, no. 75, 19th July 1977, page 1435 C 77; & JP-A-52 38 484 (KAWASAKI JUKOGYO K.K.) 25-03-1977**

**PATENT ABSTRACTS OF JAPAN, vol. 10, no. 131 (C-346)[2188], 15th May 1986; & JP-A-60 255 966 (MITSUBISHI KINZOKU K.K.) 17-12-1985**

**PATENT ABSTRACTS OF JAPAN, vol. 10, no. 36 (C-328)[2093], 13th February 1986; & JP-A-60 187 669 (NIHON TUNGSTEN K.K.) 25-09-1985**

**PATENT ABSTRACTS OF JAPAN, vol. 5, no. 144 (C-71)[816], 11th September 1981; & JP-A-56 75 569 (NIPPON SHINKU GIJUTSU K.K.) 22-06-1981**

(73) Proprietor: **HAUZER HOLDING B.V.
Groethofstraat 27
NL-5916 PA Venlo(NL)**

(72) Inventor: **Wesemeyer, Harald
Kleinfischbach 15
W-5276 Wiehl 2(DE)**
Inventor: **Veltrop, Hans
Burg. Termeerstraat 61
NL-5971 VL Grubbenvorst(NL)**

(74) Representative: **van der Beek, George Frans, Ir. et al
Nederlandsch Octrooibureau Schevening-seweg 82 P.O. Box 29720
NL-2502 LS 's-Gravenhage(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a method according to the preamble of claim 1.

Such a method is known from EP-A-0 099 724. In said specification a plasma arc method is described wherein the cathode is provided with a bore through which material is added to the arc drawn between the cathode and anode. This material is transported in the plasma generated by the arc drawn. To provide even distribution of the material on the inside surface of the anode to be coated Helmholtz coils are used outside of the device to control the place of deposition of the material evaporated. It is important that the arc will not constantly remain on the same spot on the anode surface, because local heating will occur effecting the properties of the material deposited. Through the use of Helmholtz coils even deposition of material on the anode is guaranteed.

The invention is realized with the method described above with the characterizing features of claim 1. By using the athodic arc deposition process a layer of relatively even thickness and improved adherence can be deposited. According to the invention the cathode is a hollow body of revolution inside which a magnetic field is generated to control the position of the arc on the outer cathode surface. In this way consumption of the cathode surface can be controlled. In contrast to the abovementioned European application the magnetic field functions to control the position of the cathode spot and not of the anode spot.

In GB-A-2,139,648 an anode-cathode arrangement is described wherein the anode is positioned outside of the cavity and the cathode inside of the cavity to be coated. The anode has a small spacing from the cathode. The arc occurring during cathode arc deposition will not only extend in the space between the anode and cathode, but will also wander spirally on the cathode. The move ment of the arc on the cathode surface is uncontrolled and gives rise to uneven deposition of the material evaporating from the cathode on the substrate to be coated. Also the quality of the material migrating is impaired by the randomly wandering arc. A first phenomenon which is observed is that more material is evaporated from the cathode on a spot near the anode than on a spot removed from the anode.

According to a preferred embodiment of the invention the cathode arc deposition device and the cavity to be coated are moved relative to each other. In this way uniform coating of the cavities is ensured on the one hand and the cathode surface is used in uniform way on the other hand. In a very simple embodiment the object can be connected as anode. This means that between the object and the cathode an arc is directed, and that the positive tail of the arc goes to the object.

The invention also relates to a device for realizing the method described above having the features according to claim 5.

The means for controlling the path of the arc on the cathode surface can e.g. comprise the means described in EP-A-0 284 145 and EP-A-0 283 095.

According to a further embodiment the cathode-anode arc deposition device comprises an elongate body on which joiningly a cathode and anode surface are provided. The cathode surface can be delimited by arc delimiting means.

The invention will be described below referring to the enclosed figures to further elucidate the invention. In the drawing shows:

Figure 1 a side elevation in cross section of a cathode arc deposition device arranged in a tube to be coated;

Figure 2 a cross sectional view II-II of figure 1;

Figure 3 a view similar to figure 2 of an alternative cathode supporting device;

Figure 4 a detail of the cathode of figure 1 in cross section provided with the arc controlling device according to the invention;

Figure 5 schematically the electric circuit used with the cathode arc deposition device in which the article to be coated is connected as anode; and

Figure 6 the circuitry according to figure 5 in which the article to be coated does not form cathode or anode.

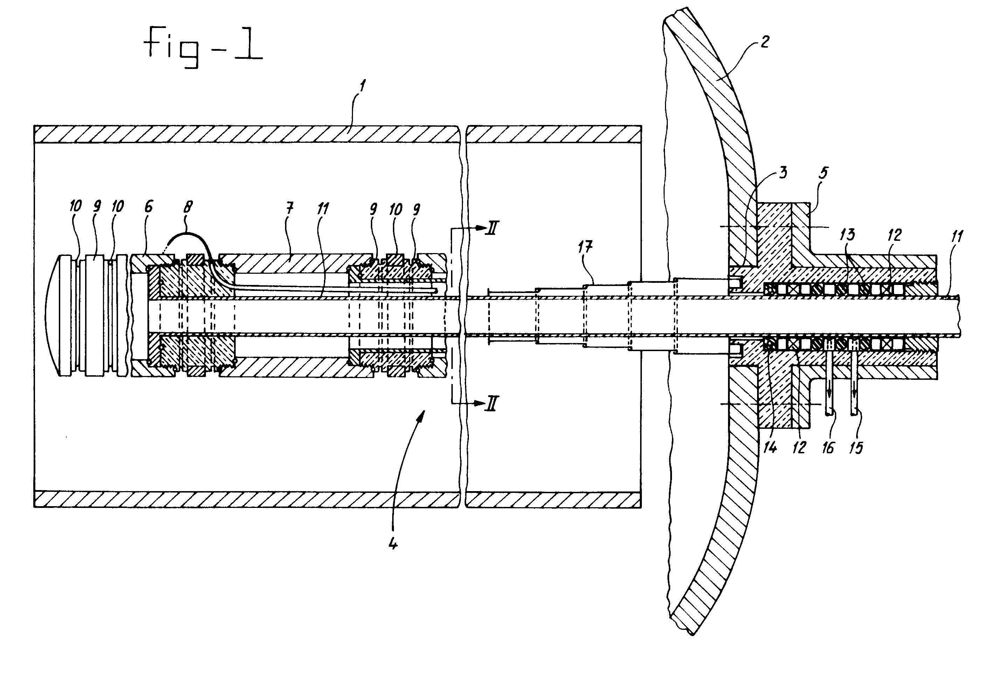

In fig. 1 the tube to be coated is referred to with 1. This tube is arranged in vessel 2, which is only partly shown. In this vessel 2, an opening 3 is provided, through which the cathode arc vaporizing device, generally indicated with 4, can be introduced. With flange 5 this device 4 can be sealingly connected to vessel 2. Vessel 2 is a vacuum vessel. As shown the cathode arc deposition device is introduced in tube 1. This cathode arc deposition device comprises cathode 6 and an anode 7. Furthermore an ignition wire 8 is provided near the cathode surface. This wire is connected with a high voltage source (not shown). For further details relating to the circuitry reference is made to EP-A 253435 Between cathode 6 and anode 7 a ring 9 of magnetic soft material is arranged. This ring 9 is delimited on both sides by a labyrinth structure 10. This structure 10 comprises a number of dark spaces being connected in series. The assembly of ring 9 and labyrinth 10 has to prevent that during operation of the device the arc extinguishes, wanders from the cathode respectively. Cathode 6 and anode 7 can also be provided with cooling systems, not shown. For moving the cathode relative to the tube, the cathode 6 is arranged on a movable rod 11.

Through an assembly of ball bearings 12 and sealings 13, combined with a sleeve 14 for stopping dirt entering, a stable guiding for rod 11 is provided, sealing as well as possible. For limiting the effects of possible leaks to the vacuum two connections 15 and 16 are provided, wherein the connection 15 is connected with a vacuum prepump and connection 16 is connected with a high vacuum pump. To prevent coating of the part of the rod 11 being within the vacuum vessel 2, this is provided with a telescoping shielding structure 17.

The device as descibed above operates as follows:

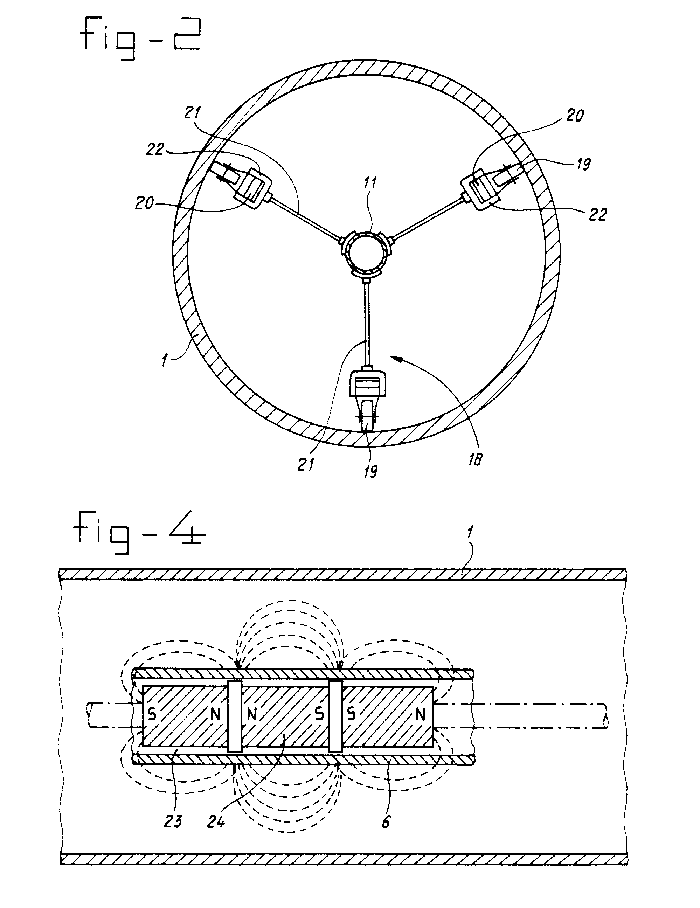

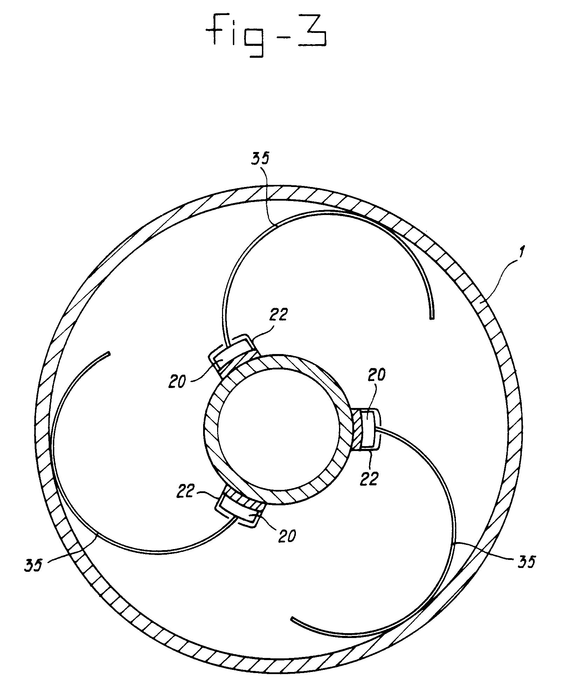

After introducing the tube 1, which has to be coated internally and after arranging the cathode arc depositing device, vessel 2 is evacuated. If the under pressure is sufficient an arc is ignited between anode 7 and cathode 6 by igniton wire 8. This arc runs along the cathode surface and from the cathodic surface material migrates to the surface of the tube to be coated. This arc is in the form shown in figure 1 and 2, uncontrolled. Referring to Fig.4 an embodiment will be described wherein the path of the arc is controlled. By moving rod 11 to and fro all of the internal surface of the tube to be coated can be provided with a layer of material.

To prevent the rod 11 from bending, a centering device is provided, generally referred with 18. For details reference is made to fig. 2. From this figure is it clear that this device comprises three rollers 19, being connected with rod 11 through isolating members 20 and legs 21 provided with springs. It is also possible to arrange this device 19 more nearly to the cathode and in this case shieldings 22 can provide a dark space. It is also imaginable to secure the cathode arc deposition device outwardly on both sides of the tube and move it to and fro between its mounting points.

In fig. 3 a more simple embodiment or the device according to fig. 2 is shown. Instead of rollers 19 resilient arms 35 are used. A combination of a centering effect and adaption to the inside diameter of the tube to be coated is obtained by this measure.

In fig. 4 a detail of fig.1 is shown, being the part near cathode 6. In contrast to fig. 1 a permanent magnet assembly generally referred to with 23, is arranged. Magnetic field lines are schematically shown. In this embodiment at the spot of the central magnet 24 a narrow arc path is formed extending around the cathode surface 6. By moving this assembly 23 within the cathode the surface of the cathode can be uniformly used. If only one permanent magnetic is used instead of three as shown, the field lines of this magnet will have a more flattened shape, by which a wider path of the arc will result. It has to be understood that instead of a permanent magnet assembly 23 an electric coil device can be used, by which only by controlling different coils controlling the arc can be obtained without having to rely on movable parts. For this reference is made to EP-A-0 283 095.

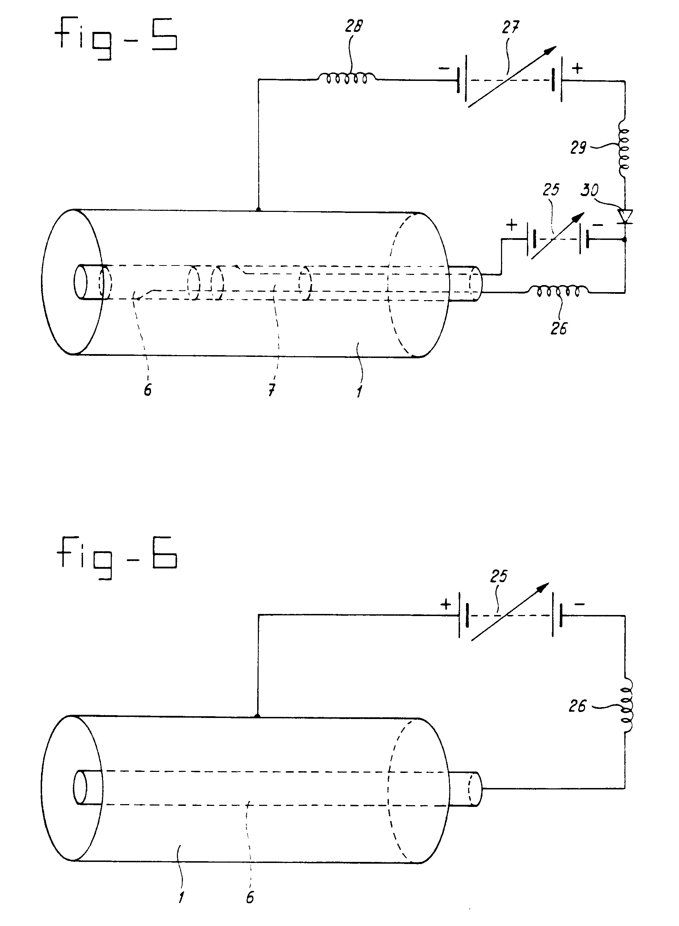

In fig. 6 schematically a circuitry is shown in which the tube 1 is connected as anode. The cathode 6 comprises an elongated tube which can be inserted in tube 1. Power is provided by source 25 and a coil 26 is connected in series for stabilizing the arc current between the anode and cathode extinguishes by which ignition is possible. In tube 6 means for controlling the arc as described above are provided.

Finally in fig. 5 a circuitry is shown in which the tube 1 is not connected as anode. This embodiment is preferable when one desires to obtain a further improved adherence between the material to be deposited and the tube to be coated because not only atoms but also ions are deposited. This advantage is accompanied by the more complicated embodiment shown in fig. 5 with regard to the embodiment shown in fig. 4. In fig. 5, also a source 27 is shown for applying a negative voltage for sputter cleaning and ion implanting of for instance 1000 V on tube 1. Coil 28 is a flattening coil, whilst coil 29 functions to prevent radio frequent oscillations. Diode 30 has a safety function.

## Claims

1. Method for coating cavities of objects, such as the internal surface of tubes, wherein a cathode is at least partially introduced in the cavity to be coated, material being deposited from the cathode onto the internal surface of said cavity and wherein a magnetic field is used, **characterized in that** the method comprises cathodic arc deposition, wherein said material evaporates from the cathode surface, the cathode is a hollow body of revolution and the magnetic field is generated by means provided inside this body to control the position of the arc on the cathode surface.

2. Method according to claim 1 wherein the cathode and the cavity to be coated are moved relative to each other.

3. Method according to one of the preceding claims, wherein the article is connected as arc anode.

4. Method according to one of the preceding claims, wherein an anode assembly is used not connected to the article to be coated.

5. Device for realizing the method according to one of the preceding claims, comprising an anode, a cathode, means for generating a magnetic field and means for establishing vacuum in an anode-cathode space, characterized in that the cathode is a hollow body of revolution, being provided internally with the means for generating a magnetic field at its outer surface and having centering means to position the cathode inside a cavity to be coated.

6. Device according to claim 5, in combination with the cavity to be coated, wherein the surface of the cathode is shaped substantially corresponding to the surface of the cavity to be coated.

7. Device according to one of the claims 5 or 6, wherein the cathode arc deposition device comprises an elongated body on which the cathode and anode surface are joiningly provided.

8. Device according to one of the claims 5-7, wherein the cathode surface is limited by arc confinement means.

**Patentansprüche**

1. Verfahren zum Beschichten von Hohlräumen von Gegenständen, wie die Innenflächen von Rohren, wobei eine Kathode mindestens teilweise in den zu beschichtenden Hohlraum eingeführt wird, Material von der Kathode auf der Innenfläche des Hohlraums abgelagert wird und wobei ein Magnetfeld verwendet wird, **dadurch gekennzeichnet,** daß das Verfahren eine kathodische Lichtbogen-Ablagerung aufweist, wobei das Material von der Kathodenfläche verdampft, die Kathode ein hohler Drehkörper ist und das Magnetfeld von Einrichtungen erzeugt wird, die in dem Körper angeordnet sind, so daß die Position des Lichtbogens auf der Kathodenfläche gesteuert wird.

2. Verfahren nach Anspruch 1, wobei die Kathode und der zu beschichtende Hohlraum relativ zueinander bewegt werden.

3. Verfahren nach einem der vorstehenden Ansprüche, wobei der Gegenstand als Lichtbogenanode verbunden ist.

4. Verfahren nach einem der vorstehenden An-sprüche, wobei eine Anodenanordnung ver-wendet wird, die nicht mit dem zu beschichtenden Gegenstand verbunden ist.

5. Vorrichtung zur Durchführung des Verfahrens nach einem der vorstehenden Ansprüche, mit einer Anode, einer Kathode, einer Einrichtung zum Erzeugen eines Magnetfelds und einer Einrichtung zum Herstellen eines Unterdrucks in einem Anoden-Kathodenraum, **dadurch gekennzeichnet,** daß die Kathode ein hohler Drehkörper ist, der im Innern mit der Einrichtung versehen ist zum Erzeugen eines Magnetfelds an ihrer Außenfläche und Zentriereinrichtungen aufweist zum Positionieren der Kathode im Innern eines zu beschichtenden Hohlraums.

6. Vorrichtung nach Anspruch 5, in Verbindung mit dem zu beschichtenden Hohlraum, wobei die Kathodenfläche im wesentlichen entsprechend der Fläche des zu beschichtenden Hohlraums geformt ist.

7. Vorrichtung nach einem der Ansprüche 5 oder 6, wobei die Kathodenlichtbogenbeschich-tungsvorrichtung einen längsgestreckten Kör-per aufweist, auf dem die Kathoden- und Anodenfläche gemeinsam vorgesehen sind.

8. Vorrichtung nach einem der Ansprüche 5 bis 7, wobei die Kathodenfläche durch Lichtbogen-Begrenzungseinrichtungen begrenzt ist.

**Revendications**

1. Procédé pour revêtir des cavités d'objets, telles que la surface intérieures de tubes, dans lequel une cathode est introduite au moins partiellement dans la cavité à revêtir, une matière étant déposée à partir de la cathode sur la surface intérieure de ladite cavité et dans lequel on utilise un champ magnétique, **caractérisé** en ce que le procédé comprend un dépôt cathodique par arc, ladite matière s'évaporant de la surface de la cathode, la cathode étant un corps de révolution creux et le champ magnétique étant engendré par un moyen disposé à l'intérieur de ce corps pour commander la position de l'arc sur la surface de la cathode.

2. Procédé selon la revendication 1, dans lequel on déplace l'une par rapport à l'autre la cathode et la cavité à revêtir.

3. Procédé selon l'une quelconque des revendications précédentes, dans lequel on relie l'article en tant qu'anode d'arc.

4. Procédé selon l'une quelconque des revendications précédentes, dans lequel on utilise un ensemble formant anode qui n'est pas relié à l'article à revêtir.

5. Dispositif pour mettre en oeuvre le procédé selon l'une quelconque des revendications précédentes, comprenant une anode, une cathode, un moyen pour engendrer un champ magnétique et un moyen pour établir un vide dans un espace anode-cathode, **caractérisé** en ce que la cathode est un corps de révolution creux pourvu intérieurement du moyen servant à engendrer un champ magnétique à sa surface extérieure et comportant un moyen de centrage pour positionner la cathode à l'intérieur d'une cavité à revêtir.

6. Dispositif selon la revendication 5, en combinaison avec la cavité à revêtir, dans lequel la surface de la cathode est configurée d'une façon sensiblement correspondant à la surface de la cavité à revêtir.

7. Dispositif selon l'une quelconque des revendications 5 ou 6, dans lequel le dispositif de dépôt cathodique par arc comprend un corps allongé sur lequel sont réunies la surface de cathode et la surface d'anode.

8. Dispositif selon l'une quelconque des revendications 5 à 7, dans lequel la surface de cathode est limitée par un moyen de confinement d'arc.

fig-1

EP 0 298 157 B1

Fig-2

Fig-4

fig-3

Fig-5

Fig-6